# EUROPEAN PATENT APPLICATION

(11) **EP 2 557 599 A1**
(43) Date of publication of application: **13.02.2013**
(21) Application number: 11766039.9
(22) Date of filing: 06.04.2011
(51) Int. Cl.: H01L 31/04, G01N 21/65, G01N 21/66, G01N 21/88, G01N 25/72

(54) **INSPECTION METHOD AND INSPECTION DEVICE FOR SOLAR CELL**

(30) Priority: 09.04.2010 JP 2010090110
(71) Applicant: Nisshinbo Mechatronics Inc., Tokyo 103-8650 (JP)
(72) Inventor: NAKAHAMA Hidenari, (JP); MAEDA Shuji, (JP); NAKANO Hiroshi, (JP)
(74) Representative: Isarpatent
(86) International application number: PCT/JP2011/059127
(87) International publication number: WO 2011/126141

(57) **Abstract**

The present invention provides an inspecting apparatus for photovoltaic devices and a method of determining defects in photovoltaic devices, which can improve the inspection accuracy.

The second inspecting apparatus 30 applies a current to photovoltaic cells of which photovoltaic devices is composed and make the photovoltaic devices emit EL emitting light. The defective portion is predetermined based on the fact that a non-defective portion emits EL emitting light and a defective portion emits weak EL emitting light or no EL emitting light. The third inspecting apparatus 40 applies an electric current to photovoltaic devices and a defective portion is heated. The thermograph image is obtained by the thermograph photographing means and the portion which has high temperature is predetermined to be defective. The first inspecting apparatus 20 inspects with Raman spectrometric method a point predetermined to be defective by comparing and verifying the portions predetermined to be defective by two methods.

## Description

### PRIORITY CLAIM

The present application is a continuation of PCT/JP2011/59127, filed on April 6, 2011, and is related to and claims priority from Japanese patent application no. 2010-90110 (filed on April 9, 2010). The entire contents of the aforementioned application are hereby incorporated by reference herein.

### BACKGROUND OF THE INVENTION

### Field of the Invention

The present invention relates to an inspecting method and an inspecting apparatus which is employed to inspect a photovoltaic devices which has not less than one cell.

### Description of the Background Art

It is well known that a silicon photovoltaic devices is employed to harness solar energy. In the manufacture of the photovoltaic devices, it is important to evaluate whether the photovoltaic devices has predetermined power generation capacity. The evaluation is usually performed by measuring output characteristics of the photovoltaic devices with a solar simulator(for example, refer to the Patent Document 1.

The following method different from the solar simulator is disclosed in the Patent Document 2. By applying a voltage to a polycrystalline silicon photovoltaic devices element in a forward direction, the photovoltaic cells element emits electro-luminescence light (hereinafter referred to simply as a "EL light"). The photovoltaic cell is inspected thereby whether it is passed or not. By studying the EL light emitted from the photovoltaic cell, it is able to obtain the distribution of the current density of the photovoltaic cell. The portion which emits no EL light is determined to be a defective portion on the basis of the uneven distribution of the current density. If the measured amount of the EL light from the photovoltaic cell has the predetermined value, it is decided to be non-defective. If not, it is determined to be defective.

The inspecting method described in the Patent Document 2 determines only on the brightness of the EL light from the photovoltaic cell whether it is passed or not. Therefore, if it has a large crack and the brightness of the large crack is beyond the predetermined value, it is determined to be non-defective. However, if it has a large crack,
Its performance may rapidly deteriorate and it shall be determined to be defective.

In the Patent Document 3, the defects of a photovoltaic device are classified into external defects caused by external factors such as a substrate crack, an electrode fracture, and a loose contact; and internal defects caused by physical properties of a substrate such as a crystalline defect, a transition, and a grain boundary.
In measuring emitting EL light, the photovoltaic cell is heated by considering the fact that internal defects are temperature-dependent. According to the technique, the internal defects weaken and thus the external defects are easily detected. The defects of a photovoltaic device are easily classified into external defects and internal defects.

The following method is disclosed in the Patent Document 4. By applying a current to photovoltaic devices in a forward direction, the temperature profile is photographed and the defective portion is detected. This method employs the following fact. By applying a current to photo voltaic devices, much current flows into a short-circuit portion and the temperature of the short-circuit portion rises. However, since the sensitivity and resolution of this method is bad, the defects of photovoltaic devices in not exactly detected.

The following method is disclosed in the Patent Document 5. The power means applies a current to photovoltaic cells in photovoltaic devices to be measured and the photovoltaic cell emits light. The emitting light of each photovoltaic cell is photographed by photographing means. The analyzing means calculates a threshold value based on an average brightness of a region of the photographed image where bright and dark parts are mixed in respect to the photographed image of the photovoltaic cell by using the photographing means. The analyzing means divides the photographed image into bright and dark regions based on the threshold value, enhances the bright and dark regions by binarizing and displaying the bright and dark regions, and determines existence of a defect for each photovoltaic cell of the photovoltaic devices.

According to the method of determining a defect of a photovoltaic devices of the Patent Document 5, defects are classified into three types: [dark area], [crack in substrate], and [finger break]. The sizes(areas, lengths) and numbers of detected [dark area], [finger breaks], and [cracks] are compared with predetermined threshold values of three types. Therefore, defects of a photovoltaic devices is determined in a short time.
Patent Document 1: JP-2007-88419-A
Patent Document 2: WO/2006/059615
Patent Document 3: WO/2007/129585
Patent Document 4: JP-1996-37317-A
Patent Document 5: JP-4235685-B

### SUMMARY OF THE INVENTION

However, in Patent Document 5, there may be the case that it is difficult to distinguish the micro crack from the grain boundary. By additional inspection, the defect which is determined to be micro crack may be re-determined to be the grain boundary or defect caused by a mixing foreign substance. Conversely, the grain boundary may be mis-determined to be the micro crack.

The present invention has been accomplished in view of the aforementioned problems. The objective of the present invention are to provide photovoltaic devices inspection apparatus and a method of determining defects in photovoltaic devices, which can improve the inspection accuracy.

To attain the objectives described above, the inspecting apparatus for photovoltaic devices according to the present invention includes the following configurations.
1. An inspecting apparatus for determining whether a photovoltaic device having not less than one photovoltaic cell is qualified or not includes: a first inspecting apparatus; a second inspecting apparatus; and/or a third inspecting apparatus.
   The first inspecting apparatus includes: an illuminating means configured to irradiate a leaser beam to a inspecting point on the photovoltaic device as an inspecting object; a diffracting means configured to separate a Raman scattered light scattered from the inspecting object at the inspecting point into a spectrum; and a spectrum analyzing means configured to analyze a state of the photovoltaic devices at the inspecting point on the basis of the spectrum obtained by the diffracting means from the Raman scattered light.
   The second inspecting apparatus includes: a power means configured to apply a current to the photovoltaic devices as the inspecting object; an photographing means of emitting light configured to photograph an emitting light emitted from the photovoltaic devices to which a current is applied by the power means, and an analyzing means of EL image configured to analyze an image of the photovoltaic device photographed by the photographing means of emitting light.
   The third inspecting apparatus includes: a heating means configured to heat the photovoltaic devices as the inspecting object; a photographing means of thermograph image configured to measure a temperature of the photovoltaic devices heated by the heating means; and an analyzing means of thermograph image configured to analyze an image of the photovoltaic devices photographed by the photographing means of thermograph image.
2. The photographing means of emitting light in the second inspecting apparatus may be disposed at a front face side of the photovoltaic devices, and the photographing means of thermograph image in the third inspecting apparatus may be disposed at a back face side of the photovoltaic devices.
3. The inspecting apparatus for the photovoltaic devices may be composed of all of the first inspecting apparatus, the second inspecting apparatus, and the third inspecting apparatus.
4. A focal point of the irradiating means in the first inspecting apparatus may be movable in three axial directions of x, y and z.
5. The photovoltaic devices as the inspecting object may be a photovoltaic devices panel having a laminated structure: a plurality of photovoltaic cells connected electrically are arranged in two dimensions and are sandwiched by a transparent protective layer at a front face side and a back sheet at a back face side through the intermediary of a sealing resin.
6. The heating means of the third inspecting apparatus may apply an current to the photovoltaic devices as the inspecting object.
7. An inspecting method of a photovoltaic devices includes steps of: applying a current to the photovoltaic devices as an inspecting object by using a power means; photographing an emitting light emitted from each photovoltaic cell due to applying a current to the photovoltaic devices by using the photographing means of emitting light; specifying a location predetermined to be defective position by an analyzing means of EL image from an image of the photovoltaic devices photographed by the photographing means of emitting light; heating the photovoltaic devices by using a heating means; photographing a temperature profile of the photovoltaic devices due to the heating by using a photographing means of thermograph image; specifying a location predetermined to be a defective position by an analyzing means of thermograph image from an image of the photovoltaic devices photographed by the photographing means of thermograph image; irradiating a leaser beam by using an irradiating means to an inspecting point predetermined to be the defective position by the analyzing means of EL image and/or the analyzing means of thermograph image; separating a Raman scattered light scattered from the inspecting point at which the laser beam is irradiated into a spectrum by using a diffracting means; and analyzing a state of the photovoltaic device at the inspecting point on the basis of the spectrum of Raman scattered light separated by the diffracting means.
8. The photographing means of emitting light may be configured to photograph the photovoltaic devices from a front face side thereof, and the photographing means of thermograph image is configured to photograph the photovoltaic devices from a back face side thereof.
9. The step of heating the photovoltaic devices by the heating means may be performed by applying a current to the photovoltaic devices.
10. The photographing means of emitting light and the photographing means of thermograph image photograph the photovoltaic devices from a front face side and a back sheet at a back face side. The inspecting point at which the laser beam be irradiated may be determined by overlapping the locations predetermined to be the defective positions by the analyzing means of EL image and the analyzing means of thermograph image, respectively.
11. The photovoltaic device to be inspected may be a photovoltaic devices panel having a laminated structure: a plurality of photovoltaic cells connected electrically are arranged in two dimensions and are sandwiched by a transparent protective layer at a front face side and a back sheet at a back face side through the intermediary of a sealing resin. And the inspecting method further may include steps of: irradiating the laser beam into the transparent protective layer and/or the filling member; obtaining a spectrum from the obtained Raman scattered light; and determining a defective state of the transparent protective layer and/or the filling member on the basis of the spectrum.

In the present invention, first, the second inspecting apparatus 30 applies a current to photovoltaic cells of which photovoltaic devices is composed and make the photovoltaic devices emit EL light. The defective portion is predetermined based on the fact that a non-defective portion emits EL light and a defective portion emits weak EL light or no EL light.

Next, the third inspecting apparatus 40 applies a current to photovoltaic devices and a defective portion is heated. The thermograph image is obtained by the photographing means of thermograph image and the portion which has high temperature is predetermined to be defective.

First inspecting apparatus 20 inspects with Raman spectrometric method a point predetermined to be defective by comparing the portion predetermined to be defective by EL method of second inspecting apparatus with the portion predetermined to be defective by thermograph method and verifying. By Raman spectrometric method, the status of crystalline silicon, the status of transparent protective layer and filling member can be analyzed.

In the above configuration, first inspecting apparatus, second one and third one are used. However, the following configuration may be employed: either the second inspecting apparatus or the third inspecting apparatus extracts the portion predetermined to be defective and then Raman spectrometric method of the first inspecting apparatus inspects the defective portion. This inspecting method leads to accurate inspection.

According to the inspecting method and inspecting apparatus for photovoltaic devices of the present invention, defects of photovoltaic devices are exactly inspected. Since the cause may be specified, the apparatus and the method of the present invention can prevent the occurrence of defects and improve a yield.

Since the apparatus and the method of the present invention can be determined whether a defect grows or not in the future according to a type of a defect, a potential defect as well as a current defect can be determined. Therefore, the apparatus and the method of the present invention can improve the reliability of the inspection in the case that photovoltaic devices is used for extended period of time.

Other features and advantages of the present invention will be apparent from the following description when taken in conjunction with the accompanying drawings, in which like reference characters designate similar or identical parts throughout the several views thereof.

### BRIEF DESCRIPTION OF THE DRAWINGS

Fig.1A is a planar view schematically illustrating the photovoltaic devices panel as an inspecting object by the inspecting apparatus;
Fig.1B is a sectional view illustrating laminated structure;

Fig.2 is a planar view from the direction of a receiving optical side of the photovoltaic cell;

Fig.3 is a view schematically illustrating a configuration of the inspecting apparatus for photovoltaic devices of the present invention;

Fig.4 is a enlarged view of the first inspecting apparatus;

Fig.5A is a photographed image of the state that the second inspecting apparatus makes photovoltaic devices panel emit light by photographing means of emitting light;
Fig.5B is a thermograph image obtained by heating photovoltaic devices panel with the third inspecting apparatus;

Fig.6A and Fig.6B is a drawing of Fig.5A and Fig.5B;

Fig. 7 is a view overlapped Fig.6A and Fig.6B;

Fig.8A is a spectrum diagram illustrating an example of inspection with Raman spectrometric method in the non-defective state;
Fig.8B is a spectrum diagram in the defective state;

Fig.9A and Fig.9B are views explaining Raman shift;

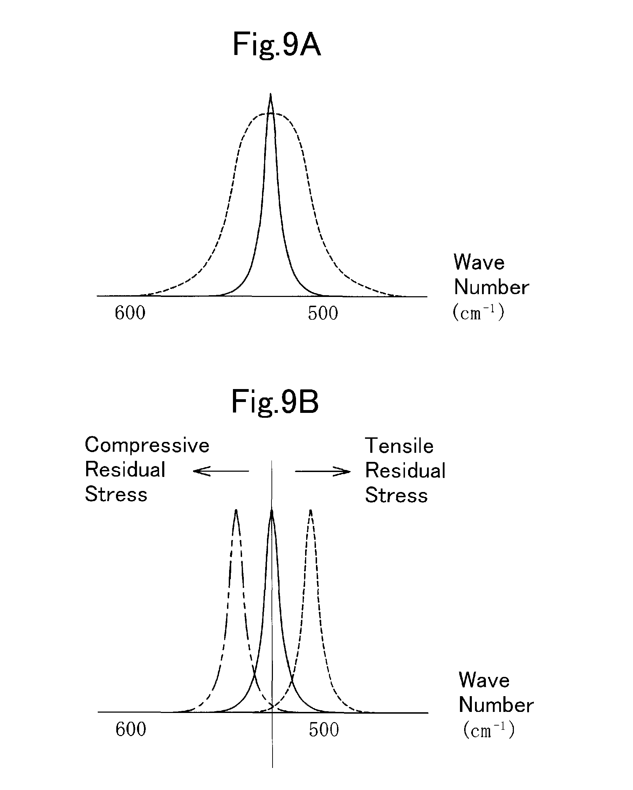

Fig.9A is a view illustrating that peak a shape changes according to silicon crystal size;
Fig.9B is a view illustrating that peak wave number changes according to residual stress in a silicon substrate.

### DETAILED DESCRIPTION OF THE INVENTION

Hereinafter, embodiments according to the present invention is described with reference to the accompanying drawings. In so doing, specific terminology is employed solely for the sake of clarity, and the present disclosure is not to be limited to the specific terminology so selected. It is to be understood that each specific element includes all technical equivalents that operate in a similar manner and achieve a similar result.

1. The configuration of photovoltaic devices

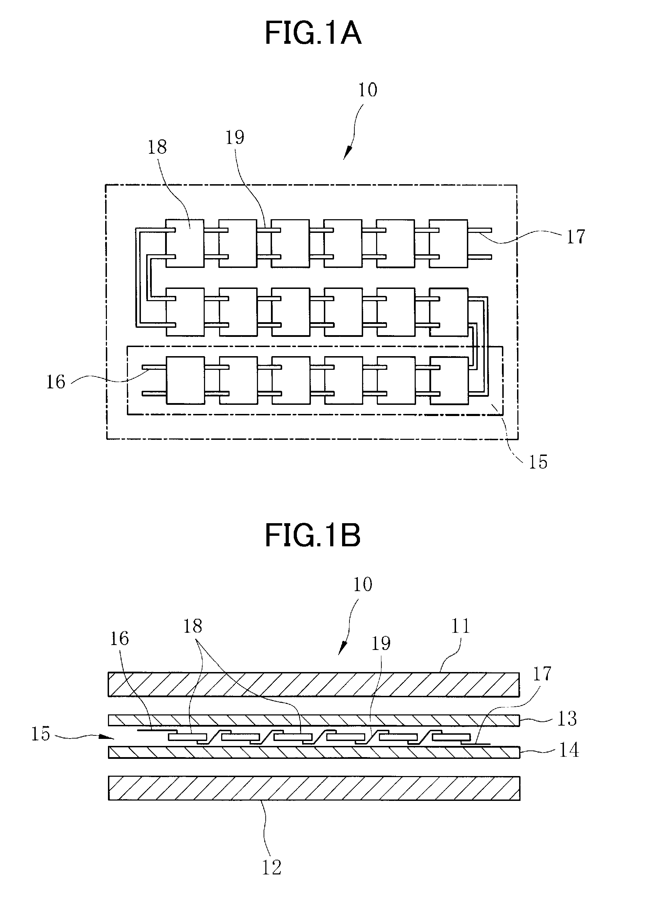

First, description is given of photovoltaic devices panel 10 of an object inspected by the inspecting apparatus of the present invention. Fig. 1A is a planar view explaining a configuration of the photovoltaic devices panel as the inspecting object. Fig. 1B is a sectional view of Fig.1A and shows the state before laminating process.

As illustrated in the planar view of Fig. 1A, the photovoltaic devices panel 10 is configured as follows: Plural square photovoltaic cells 18 are connected in series by lead wires 19 to form a string 15; Furthermore, plural columns of strings 15 are connected by lead wires 19; and electrode 16 and 17 are connected by lead wire 19 at both ends.

The photovoltaic devices panel 10 is formed as follows. As illustrated in Fig. 1B, first, a filling members 13 is disposed in a transparent cover glass 21 disposed in a lower side. The plural columns of strings 15 are disposed on the filling members 13. A filling member 14 is disposed thereon. A back member is made of opaque material and disposed on the filling member 14. The filling members 13 and 14 are made of, for example, EVA resin (polyethylene vinyl acetate resin). The photovoltaic devices panel is obtained by piling the aforementioned constructional members and laminating. The laminating process is performed by pressing with force under heating in vacuum to cross-link the EVA resin with a laminator or the like.

The inspecting object may be a single photovoltaic cell 18 only, or may be a string 15 in which the plural photovoltaic cells 18 are straightly connected, or may be a photovoltaic devices panel 10 in which the plural columns of strings 15 are disposed in parallel and the photovoltaic devices cells 28 are disposed in matrix. The inspecting object may be inspected under the state before laminating and after laminating.

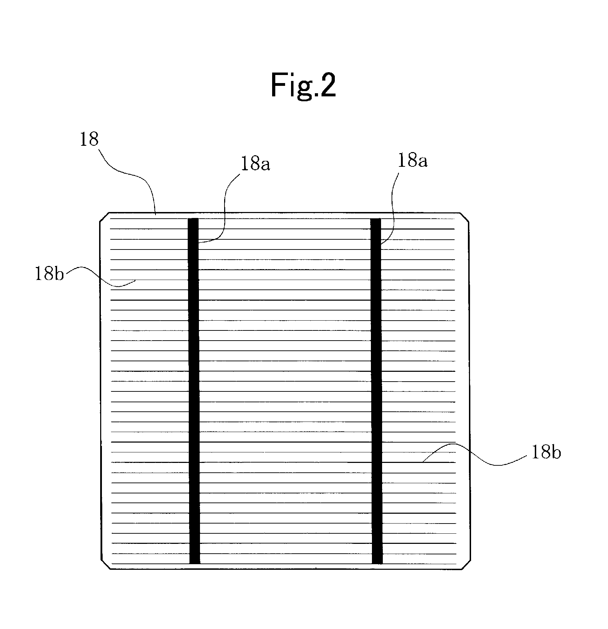

Fig.2 is a planar view from the direction of a receiving optical side of the photovoltaic cell. In the photovoltaic cell 18, busbars 18a are printed on a silicon semiconductor surface of a thin plate as electrodes for collecting electricity and taking out. In addition, fine conductors which are called as fingers are printed on the silicon semiconductor surface vertically to the busbars for efficiently collecting electricity to the busbars.

In the embodiment of Fig.2, photovoltaic devices, which is generally called as polycrystalline silicon -type, is illustrated. However, the inspecting apparatus and method of the present invention can be applied to single crystal -type photovoltaic devices and thin film-type one (i.e. amorphous silicon-type), not limited to polycrystalline-type.

2. Description of the inspecting apparatus

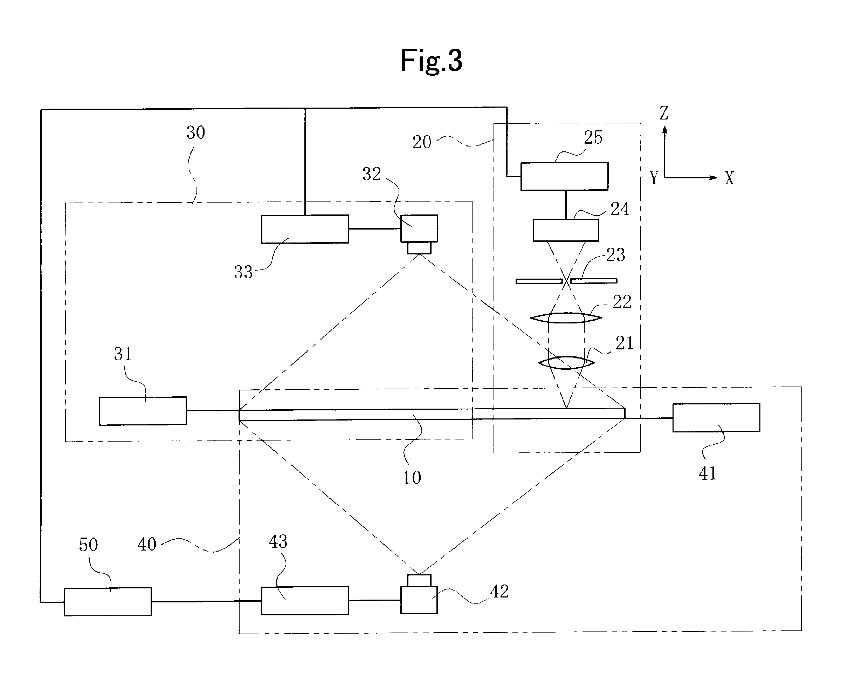

Next, description is given of configuration of inspecting apparatus for photovoltaic devices of the present invention. Fig.3 is a view schematically illustrating a configuration of the inspecting apparatus for photovoltaic devices of the present invention. The inspecting apparatus for photovoltaic devices of the present invention includes the first inspecting apparatus 20, the second inspecting apparatus 30, the third inspecting apparatus 40, and the whole control unit 50.

The first inspecting apparatus 20 employs Raman spectrometric method. The first inspecting apparatus 20 includes: object lens 21, imaging lens 22, and slit 23 as irradiating means; diffracting means 24; and spectrum analyzing means 25.

The spectrum analyzing means 25, not shown in drawings, includes a personal computer etc. The spectrum obtained through diffracting means 24 is taken in the spectrum analyzing means 25 by program implemented in a personal computer and is stored in memory. The personal computer includes a reference data file. Standard spectrum diagrams of various substances (for example, silicon, cover glass, filling member, and busbar) are stored in the reference data file, and the substance of object inspected is identified by comparing the spectrum diagram taken-in from diffracting means 24 with the spectrum diagrams stored in the reference data file.

The second inspecting apparatus 30 employs EL (Electroluminescence) method. This inspecting apparatus includes a power means 31, a photographing means 32 of emitting light, and an analyzing means 33 of EL image. The power means 31 applies a current to the photovoltaic devices as the inspecting object. The photographing means 32 of emitting light photographs EL emitting light from photovoltaic cell to which power means applies a current. The analyzing means 33 of EL image analyzes the image of photovoltaic devices panel photographed by photographing means 32 of emitting light.

The third inspecting apparatus 40 employs thermograph method. This inspecting apparatus includes the a heating means 41, a photographing means 42 of thermograph image, and an analyzing means 43 of thermograph image. The heating means 41 heats defective portions in photovoltaic cells by applying a current to photovoltaic devices panel 10. The photographing means 42 of thermograph image photographs temperature profile of photovoltaic devices panel 10 heated by the heating means 41. The analyzing means 43 of thermograph image analyzes an image photographed by the photographing means 42 of thermograph image. The power means 31 in the second inspecting apparatus may be employed as the heating means 41.

The whole control unit 50 makes the first inspecting apparatus 20, the second inspecting apparatus 30 and the third inspecting apparatus 40 perform unified motion. The whole control unit 50 includes the personal computer. Preset information is registered in the personal computer. Preset information is: Photovoltaic cell gap; number of photovoltaic cells (vertical, horizontal) of string/matrix; dimensions of photovoltaic cells 18 (busbar positions, number of busbars, corner chamfers, arrangements of finger 18b, DIP positions, etc.). The whole control unit 50 operates the first inspecting apparatus 20, the second inspecting apparatus 30 and the third inspecting apparatus 40 by the stored program. In addition, the whole control unit 50 determines the location information (i.e. x-coordinate, y-coordinate, rough z-coordinate) of the inspecting point inspected by the first inspecting apparatus on the basis of the inspecting result of the second inspecting apparatus 30 and the third inspecting apparatus 40. The whole control unit 50 includes moving mechanism and makes the fist inspecting apparatus move to the measuring point by moving mechanism. The whole control unit 50 determines the adjusted value ofz-coordinate in the inspecting point, and makes the focal position of object lens 21 transfer to the adjusted height (z-coordinate).

3. Outline of the inspection with Raman spectrometric method

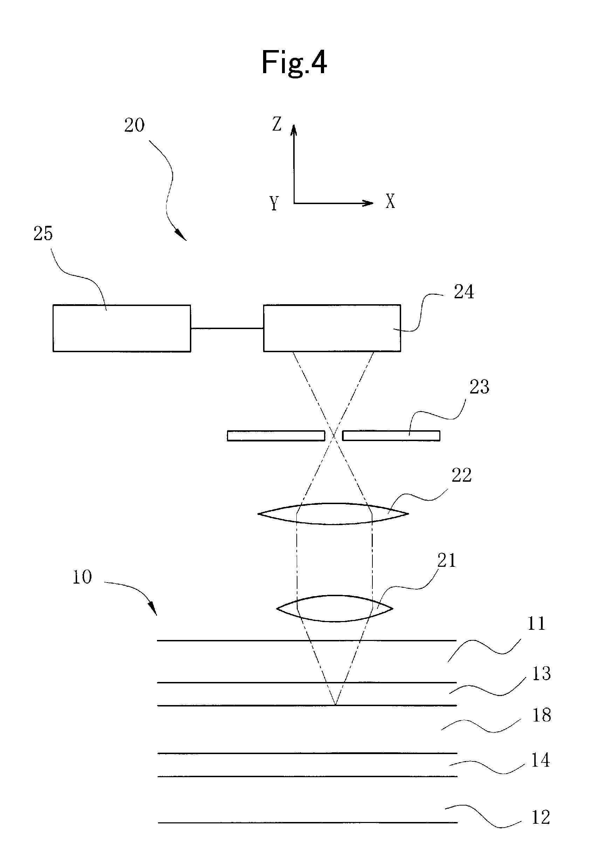

Description is given of the inspecting method with the first inspecting apparatus according to Fig.4. Object lens 21 as the irradiating means irradiates laser beam of visible light wavelength from laser source (not shown in drawings) to photovoltaic devices panel 10 as the inspecting object. Laser beam permeates through the cover glass 11 and the filling member 13 as transparent protective layer and forms a focal point on the surface of the photovoltaic cell 18. Raman scattered light is emitted from the focal point. Raman scattered light has the number of vibrations shifted from the irradiated laser beam and is the number of vibrations which substance has solely.

Raman scattered light is emitted from the focal point and the both sides thereof. However, by means of the imaging lens 22 and the slit 23, only Raman scattered light emitted from the focal point passes the slit and forms image on the diffracting means 24. The diffracting means 24 includes a diffraction grating and an image pickup device as CCD etc. to obtain the spectrum of Raman scattered light.

The spectrum obtained by the diffracting means 24 is inputted to the spectrum analyzing means 25, and is compared with the prior registered spectrum of various substances. Through the above procedure, the substance at the focal point is identified. For example, the spectrum of crystalline silicon has peak at the wave number 520 cm-1, and the spectrum of amorphous silicon has peak at the wave number 470 cm-1.

The first inspecting apparatus moves freely along X-axis, Y-axis, and z-axis. By the whole control unit 50, the inspecting apparatus moves along x-axis and Y-axis and moves to an arbitrary position in photovoltaic devices panel 10. Z-axis is the direction of movement along the optic axis of the object lens 21, and the object lens moves closely and separately to photovoltaic devices panel 10. The cover glass 11 and the filling member 13 of photovoltaic devices panel 10 are transparent. Therefore, if the focal point of the object lens 21 is between the upper surface of the cover glass 11 and the upper surface of photovoltaic cell 18, Raman scattered light in the focal point is obtained at any point.

Laser beam is focused on the surface of the photovoltaic cell 18 by the following procedure.

The first inspecting apparatus 20 moves along z-axis and moves to the position predetermined to be the surface of the photovoltaic cell 18. If the laser beam is irradiated at the position, the Raman reflected light from the focal point passes the slit 23, and forms the image on diffracting means 24. The substance in the focal point is identified by spectrum analyzing means 25, while comparing the spectrum of diffracting means 24 with the prior registered spectrum of various substances. As a result, if it becomes clear that the substance in the focal point is the cover glass 11 as the transparent protective layer, for example, the first inspecting apparatus 20 moves downward in the figure along z axis, and the above-described same procedure is performed. And if the filling member 13 is detected next, the first inspecting apparatus 20 moves along z-axis. Until the focal point of the first inspecting apparatus 20 reaches the surface of the photovoltaic cell 18, the above-described same procedure is repeated. When the first inspecting apparatus 20 descends too much and the focal point is under the surface of the photovoltaic cell 18 in the figure, since the photovoltaic cell 18 is opaque, the spectrum is not obtained by the diffracting means 24. Therefore, the focal point is determined to be under the surface of photovoltaic cell 18. Thus, the focal point is adjusted so that the object lens 21 is focused on the surface of the photovoltaic cell 18. In the embodiment of the present invention, the object lens 21 moves downward in the figure in units of submicron to several hundreds micron. And the focal point is adjusted so that the object lens 21 is focused on the surface of the photovoltaic cell 18.

In addition, the first inspecting apparatus 20 can detect the defect in the cover glass 11 or the filling member 13. Namely, the first inspecting apparatus 20 moves along z-axis so that the focal point is in the cover glass 11 or the filling member 13.

4. Outline of the inspection with EL method

The inspecting method with the second inspecting apparatus 30 is described in detail in the above-mentioned patent document 5. Therefore, EL method (EL emitting-light method) is explained briefly in the present specification. If predetermined current is supplied in a forward direction to photovoltaic devices panel 10 as the inspecting object, photovoltaic cell 18 in photovoltaic devices panel 10 is EL (electroluminescence) emitting light source and emits EL light. However, since the defective portion emits no EL light, the defect of each photovoltaic cells 18 is determined by photographing the state of EL emitting light with photographing means 32 of emitting light. The El emitting light volume which photographing means 32 of emitting light photographs is weak. Therefore, photovoltaic devices panel 10 is disposed in a dark room and the photographing means 32 photographs weak emitting light which photovoltaic devices panel emits. Therefore, a camera having high sensitivity to a weak light ray is employed as the photographing means 32. [Dark Area], [Finger Break], and [Micro Crack] are detected by EL method, and the location of defects is specified.

5. Outline of the inspection with thermograph method

The inspecting method with the third inspecting apparatus 40 is described in detail in the above-mentioned patent document 4. Therefore, thermograph method is explained briefly in the present specification. If a voltage is applied between the electrode layers of photovoltaic devices, in a portion including a defect, compared with a peripheral region, an electric field becomes more uneven and usually becomes larger. By an local, uneven, and large electric field, more current flows between the electrode layers of this portion of photovoltaic devices, compared with the peripheral region. Since a current flow leads to heat-generation, the portion including a defect can be identified as a local heat source with thermographic technology like IR thermography, liquid crystal microscopic technique, fluorescence micro thermal image formation technology, or Schlieren photography technology. In the present invention, an infrared camera is employed as the photographing means 42 of thermography image, and photographs the thermograph image from the back member 12 (lower side) of photovoltaic devices panel 10. The position predetermined to be a defective portion can be specified on the basis of the image photographing means 42 of thermography image.

6.The inspecting method of the present invention

The first inspecting apparatus 20 with Raman spectrometric method can most exactly inspect the inspecting objet among three kinds of the above-mentioned inspecting methods. However, in Raman spectrometric method, an inspecting object is a point and it is difficult to scan and inspect. If the whole photovoltaic devices panel 10 is inspected, the inspecting point is shifted little by little, and inspection must be performed in many inspecting points. As a result, inspecting time is long, and cost of the inspecting apparatus is very expensive. On the other hand, the EL emitting light method and the thermograph method can inspect the inspecting object in a short time. However, there is a problem in inspection accuracy. Therefore, in the present invention, the inspection is performed as follows. As an inspecting object, photovoltaic devices panel 10 is employed. But photovoltaic cell 18 or string 15 may be employed.

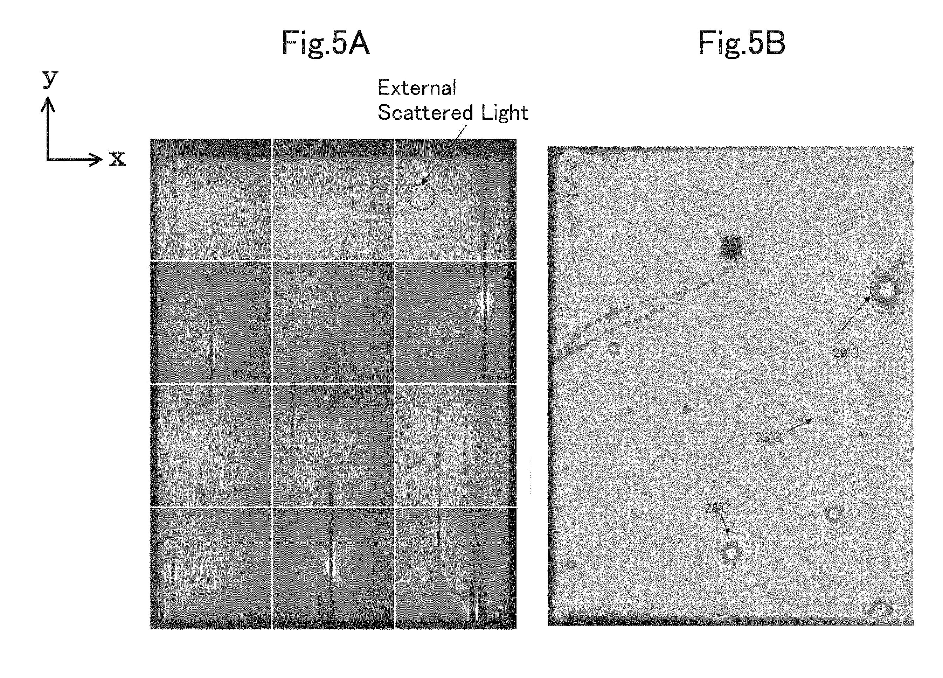

Fig. 5A shows the following image: the second inspecting apparatus 30 makes photovoltaic devices panel 10 emit EL light; the photographing means 32 of emitting light photographs the state of emitting light from front side. In the image of Fig. 5A, the defective portion is displayed as a dark line parallel to y-axis.

Fig. 5B shows the following image: the third inspecting apparatus 40 applies a current to photovoltaic devices panel 10 and heats the defective portion of photovoltaic cell 18; the defective portion is photographed as thermography image. The photographing means 42 of thermograph image is disposed under photovoltaic devices panel 10, and photographs the temperature profile from back member 12 side. In Fig.5B, the portion with a high temperature is shown as white circles. And large defects are shown as large circles, and small defects are shown as small circles. Moreover, since the third inspecting apparatus photographs the image from the back member 12 side of the photovoltaic devices panel 10, the EL emitting light method with the second inspecting apparatus and the thermograph method with the third inspecting apparatus can be performed simultaneously. Namely, Fig. 5A and Fig.5B shows the images that the same inspecting object is photographed simultaneously from the back side and front side, and the identity of the two images is secured.

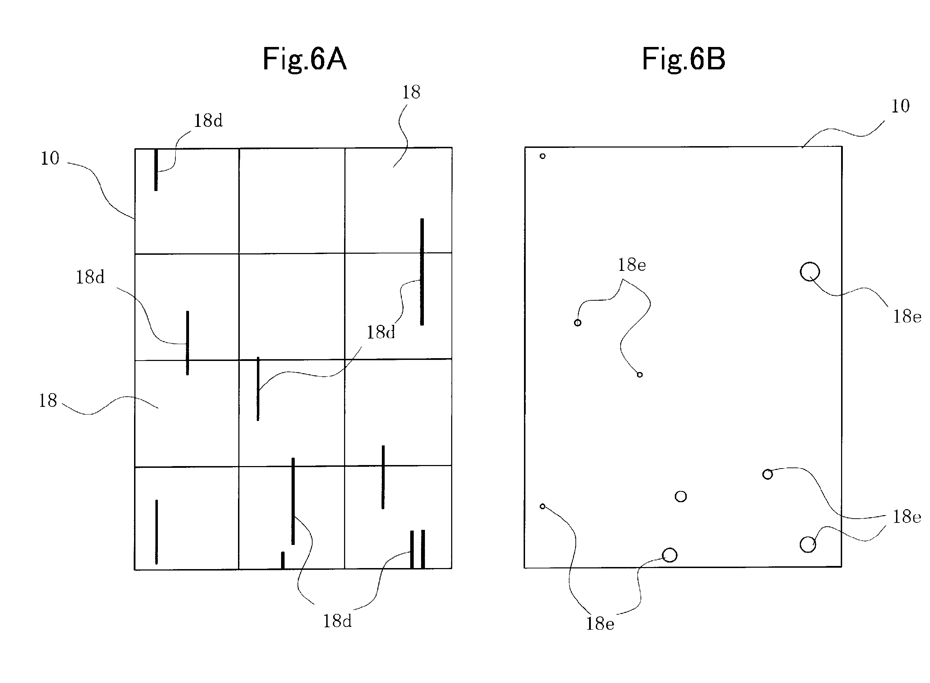

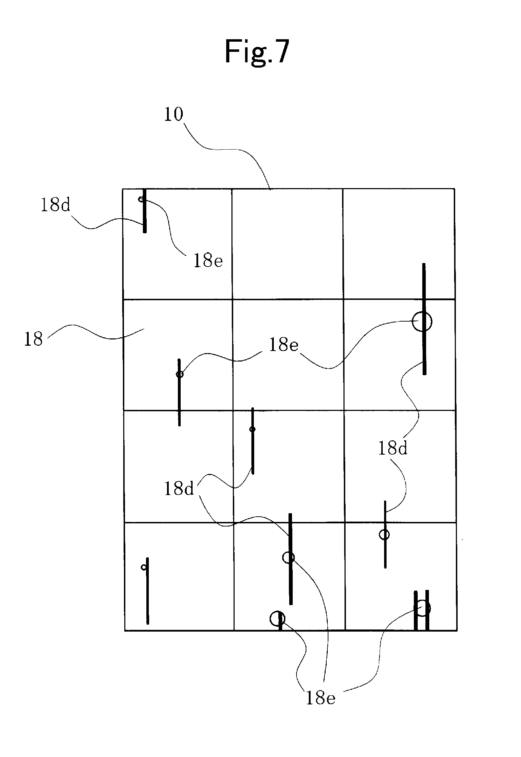

Fig. 6A and Fig. 6B are views converted Fig. 5A and Fig.5B into drawings. In the image of the state emitting EL light shown in Fig. 6A, the portion 18d predetermined to be defective is shown as a dark line parallel to y-axis. In the thermograph image shown in Fig. 6B, the portion 18e predetermined to be defective is shown as a circle. Fig. 7 is a view that on which Fig. 6A and Fig.5B overlap.
As these figures show, the portion 18d predetermined to be defective by EL emitting light and the portion 18e predetermined to be defective by thermograph method overlap mostly.

From the above results, in the present invention, the EL inspecting apparatus detects the point which has the possibility of a structured defect, and then the rough position of a defect is specified while verifying by thermograph method. The specified points are inspected by Raman spectrometric method. The following method may be employed: For example, as shown in Fig.7, the portion where the dark lines parallel to y-axis detected with the second inspecting apparatus 30 (EL inspecting apparatus) and the white circle portion detected with the third inspecting apparatus 40 (thermography inspecting apparatus) overlap is predetermined to be the defective position; the overlapped portion is inspected with the first inspecting apparatus 20 (Raman inspecting apparatus).

In Raman spectrometric method, since the small point which is the focal point of the object lens 21 is the inspecting object, only one point per the location predetermined to be defective by overlapping the image of the second inspecting apparatus and the image of the third inspecting apparatus may be inspected as the inspecting point, and several points may be. The number of inspecting points may be increases or decreases according to the size of the portion predetermined to be defective.
In the embodiment of Fig. 7, there are the nine portions where the linear defects detected by EL emitting light and the circular defects detected by thermograph method overlap. Every several points per each each portion are set as inspecting points. Although there are quite many inspecting points, compared with inspecting the whole photovoltaic devices panel 10 only by Raman spectrometric method, the number of the inspecting points decreases sharply, and inspecting time is shortened. The inspecting apparatus is manufactured cheaply.

Moreover, in the present invention, the inspecting point is specified with the above-mentioned procedure, and the focal point of the object lens is focused on the inspecting point. The focal point moves in the depth direction ,for example,200 *µ*m a once from the inspecting point, and the analytical data is collected. By performing the above-mentioned procedure, not only the focal point of the object lens is correctly focused on the surface of the photovoltaic cell 18, but the analytical data of the cover glass 11 and the filling member 13 are collected. Moreover, it is possible similarly to analyze the busbar 18a by Raman spectrometric method.

In the above-mentioned inspecting method, the overlapped portion of the defective portion predetermined by EL emitting light and the defective portion predetermined by thermograph method is inspected, but the determining method of the inspecting points is not limited to the above-mentioned method.

For example, when the defect detected by EL emitting light and the defect detected by thermograph method overlap, there is the defective portions which are detected with EL emitting light but not detected with thermograph method. Conversely, there are the defective portions which is determined to be defective with thermograph method but not determined to be defective with EL emitting light. The portion determined to be defective with either inspecting method may be the inspecting object with Raman spectrometric method. In conclusion, it is important: to consider the both sides of the defect detected by EL emitting light method and the defect detected by thermograph method; and to perform the inspection by Raman spectrometric method.

Moreover, aside from the above-mentioned embodiment, the following method may be employed: the defective portion is detected only with either the EL emitting light method or the thermograph method; the inspecting points are determined in the defective portion; and the inspecting points are inspected with Raman spectrometric method. In this case, the inspection apparatus may be provided with either the second inspection apparatus 30 or the third inspection apparatus 40, and thus is manufactured cheaply.

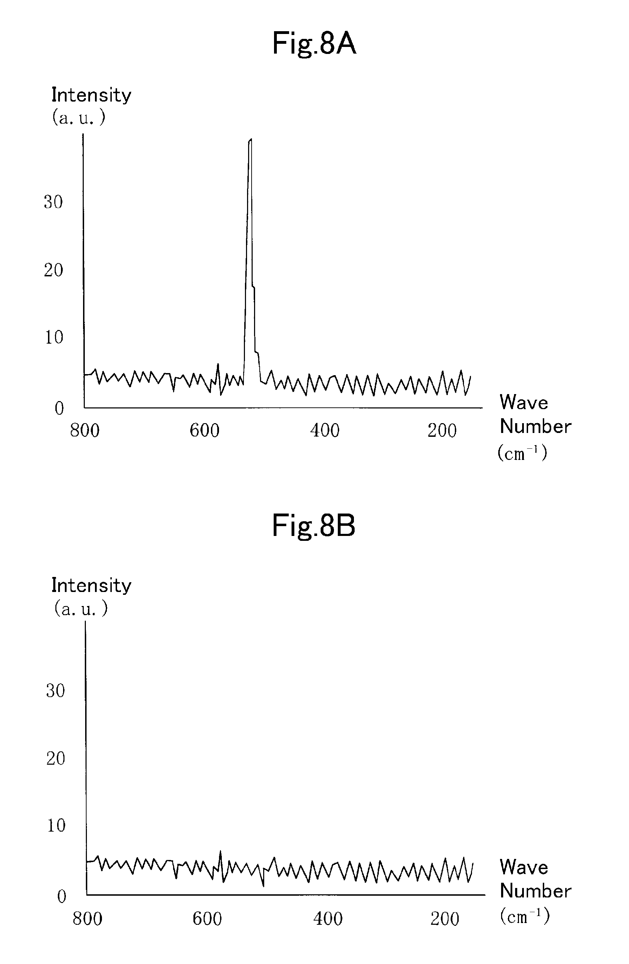

Fig.8A and Fig.8B is a spectrum diagram showing the example of defect inspection with Raman spectrometric method. Fig.8A shows a non-defective state, and Fig.8B shows a defective state.

Silicon-substrate is layered on the surface of photovoltaic cell 18. The performance and reliability of photovoltaic devices are influenced largely by the shape of surface type of the silicon substrate (smoothness) and the existence of defect (void). Fig. 8A is a spectrum diagram showing the non-defective state in silicon substrate of photovoltaic cell. Fig.8A has the peak at the wave number of approximate 520cm-1 which shows the feature of crystal system silicon. On the other hand, the spectrum diagram in Fig. 8B has no peak in the inspecting region. Therefore, it is found that the inspecting point is the state (for example, crack) where there is no silicon.

In the manufacturing process of photovoltaic devices, the deterioration of the crystallinity of a silicon substrate and the residual distortion may occur. It is well known that the adhesion of a cell, electrical resistance, the change of a band gap, initial degradation, and a life, etc are largely influenced by these.

Fig. 9A and Fig.9B is a drawing explaining a Raman shift. Fig.9A shows change of the peak shape according to the size of a silicon crystal. When the silicon crystal of a silicon substrate is large, as shown in the solid line of Fig. 9A, the steep mountain-shaped peak which has small half-width is observed. On the other hand, if silicon substrate has polycrystalline structure, as shown in the dotted line of Fig. 9A, the mountain-shaped peak which has low peak value and large half-width is observed. If a silicon substrate is amorphous, wave number of the peak shifts to 470cm-1. The mountain-shaped peak has large half-width and low peak value. The size of the silicon crystal which constitutes a silicon substrate is measured by this procedure. The problem in the manufacturing process of a silicon crystal is found.

Fig. 9B is a view showing change of a peak in the case that a silicon substrate has residual stress. In the case that a silicon substrate has no residual stress, as shown in the solid line of Fig. 9B, the wave number of the peak is 520cm-1. However, when the substrate has tensile residual stress, as shown in the dotted line of Fig.9B, a peak shifts to the right-hand side in Fig.9B. On the other hand, when the substrate has compressive residual stress, as shown in the alternate long and two short dashed line of Fig.9B, a peak shifts to the left-hand side in Fig.9B.

For example, when silicon substrate has large residual stress (i.e. a shift amount is large), a small crack may also grow greatly with passage of time. Moreover, the adhesion of a cell, electrical resistance, and the change of a band gap etc. is influenced by residual stress and the silicon substrate lacks reliability. Residual stress is not detected with conventional inspecting method, but can be detected with Raman spectrometric method. And if it is determined that silicon substrate has large residual stress, manufacturing method can be examined and the measure which makes residual stress reduce can be examined. As a result, occurrence of the defect of photovoltaic cell is prevented and improvement in quality can be attained.

In the case that impurities are mixed in a silicon crystal, a transparent protective layer or a filling member, Raman spectrometric method can detect impurities. Since mainly a problem in a manufacturing process causes mixing of impurities, the problem is easily solved with Raman spectrometric method.

As many apparently widely different embodiments of the present invention can be made without departing from the spirit and scope thereof, it is to be understood that the invention is not limited to the specific embodiments thereof except as defined in the appended claims.

## Claims

1. An inspecting apparatus for determining whether a photovoltaic devices having not less than one photovoltaic cell is qualified or not, comprising:
a first inspecting apparatus,
a second inspecting apparatus, and/or
a third inspecting apparatus,
the first inspecting apparatus including
an irradiating means configured to irradiate a leaser beam to an inspecting point on the photovoltaic devices as an inspecting object,
a diffracting means configured to separate a Raman scattered light scattered from the inspecting object at the inapecting point into a spectrum, and
a spectrum analyzing means configured to analyze a state of the photovoltaic device at the inspecting point on the basis of the spectrum obtained by the diffracting means from the Raman scattered light;
the second inspecting apparatus including
a power means configured to apply a current to the photovoltaic devices as the inspecting object,
a photographing means of emitting light configured to photograph an emitting light emitted from the photovoltaic devices to which a current is applied by the power means, and
an analyzing means of EL image configured to analyze an image of the photovoltaic devices photographed by the photographing means of emitting light; and
the third inspecting apparatus including
a heating means configured to heat the photovoltaic devices as the inspecting object,
a photographing means of thermograph image configured to measure a temperature of the photovoltaic devices heated by the heating means, and
a analyzing means of thermograph image configured to analyze an image of the photovoltaic devices photographed by the photographing means of thermograph image.

2. The inspecting apparatus for the photovoltaic device according to claim 1, wherein
the photographing means of emitting light in the second inspecting apparatus is disposed at a front face side of the photovoltaic devices, and
the photographing means of thermograph image in the third inspecting apparatus is disposed at a back face side of the photovoltaic devices.

3. The inspecting apparatus for the photovoltaic devices according to claim 1 or claim 2 is composed of all of the first inspecting apparatus, the second inspecting apparatus and the third inspecting apparatus.

4. The inspecting apparatus for the photovoltaic devices according to any of claims 1 to 3, wherein a focal point of the irradiating means in the first inspecting apparatus is movable in three axial directions of x, y and z.

5. The inspecting apparatus for the photovoltaic devices according to any of claims 1 to 4, wherein the photovoltaic devices is a photovoltaic devices panel having a laminated structure: a plurality of photovoltaic cells connected electrically are arranged in two dimensions and are sandwiched by a transparent protective layer at a front face side and a back sheet at a back face side through the intermediary of a sealing resin.

6. The inspecting apparatus for the photovoltaic devices according to any of claims 1 to 5, wherein the heating means of the third inspecting device is configured to apply a current to the photovoltaic devices as the inspecting object.

7. An inspecting method of a photovoltaic devices comprising steps of:
applying a current to the photovoltaic devices as an inspecting object by using a power means;
photographing an emitting light emitted from each photovoltaic cell due to applying a current to photovoltaic devices by using the photographing means of emitting light;
specifying a location predetermined to be a defective position by the analyzing means of EL image from an image of the photovoltaic devices photographed by the photographing means of emitting light;
heating the photovoltaic devices by using a heating means;
photographing a temperature profile of the photovoltaic devices due to the heating by using a photographing means of thermograph image;
specifying a location predetermined to be a defective position by the analyzing means of thermograph image from an image of the photovoltaic devices photographed by the photographing means of thermograph image;
irradiating a leaser beam by using an irradiating means to an inspecting point predetermined to be the defective position by the analyzing means of EL image and/or the analyzing means of thermograph image;
separating a Raman scattered light scattered from the inspecting point at which the laser beam is irradiated into a spectrum by using a diffracting means; and
analyzing a state of the photovoltaic device at the inspecting point on the basis of the spectrum of the Raman scattered light separated by the diffracting means.

8. The inspecting method of the photovoltaic devices according to claim 7, wherein the photographing means of emitting light is configured to photograph the photovoltaic devices from a front face side thereof, and the photographing means of thermograph image is configured to photograph the photovoltaic devices from a back face side thereof.

9. The inspecting method of the photovoltaic devices according to claim 7 or 8, wherein the step of heating the photovoltaic devices by the heating means is performed by applying a current to the photovoltaic devices.

10. The inspecting method of the photovoltaic device according to any of claims 7 to 9, wherein:
the photographing means of emitting light and the photographing means of thermograph image photograph the photovoltaic devices from a front face side and a back sheet at a back face side,
the inspecting point at which the laser beam is irradiated is determined by overlapping the locations predetermined to be the defective positions by the analyzing means of EL image and the analyzing means of thermograph image, respectively.

11. The inspecting method of the photovoltaic device according to any of claims 7 to 10, wherein
the photovoltaic devices is a photovoltaic devices panel having a laminated structure: a plurality of photovoltaic cells connected electrically are arranged in two dimensions and are sandwiched by a transparent protective layer at a front face side and a back sheet at a back face side through the intermediary of a sealing resin, and
the inspecting method further includes steps of
irradiating the laser beam into the transparent protective layer and/or the filling member,
obtaining a spectrum from the obtained Raman scattered light, and
determining a defective state of the transparent protective layer and/or the filling member on the basis of the spectrum.
